# EUROPEAN PATENT APPLICATION

(11) **EP 4 535 947 A1**
(43) Date of publication of application: **09.04.2025**
(21) Application number: 23814693.0
(22) Date of filing: 08.03.2023
(51) Int. Cl.: H05K 7/20, B60L 53/302

(54) **CHARGING DEVICE**

(30) Priority: 30.05.2022 CN 202221344844 U
(71) Applicant: Sungrow Power Supply Co., Ltd., Hefei, Anhui 230088 (CN)
(72) Inventor: AI, Pengli, Hefei, Anhui 230088 (CN); YANG, Ye, Hefei, Anhui 230088 (CN); XU, Linchong, Hefei, Anhui 230088 (CN)
(74) Representative: Zacco Norway AS
(86) International application number: PCT/CN2023/080243
(87) International publication number: WO 2023/231494

(57) **Abstract**

A charging device, comprising a housing, a charging unit, and fans. The housing is provided with an accommodation cavity; the housing is provided with air inlets and air outlets communicated with the accommodation cavity; the charging unit is provided in the accommodation cavity, and comprises charging modules, the charging modules being used for charging batteries; and the fans are located at the air inlets, such that cold air is injected into the accommodation cavity through the air inlets, flows through the charging modules, and is exhausted through the air outlets. According to the technical solution of the present application, the service life of the fans can be ensured, and the heat dissipation efficiency and the use safety of the charging modules can also be improved, thereby promoting the reliable usage of the charging device.

## Description

The present application claims the priority to Chinese Patent Application No. 202221344844.4, titled "CHARGING DEVICE", filed with the China National Intellectual Property Administration on May 30, 2022, which is incorporated herein by reference in its entirety.

### FIELD

The present application relates to the technical field of charging devices, and in particular to a charging device.

### BACKGROUND

A charging module, which is an important component of a charging device, generates a large amount of heat in operation, causing an increased overall heat of the charging device. In order to ensure the reliable operation of the components, it is necessary to timely cool the charging device. Currently, the adopted method is to install a cooling air blower to directly dissipate heat from the inside of the charging module, which increases costs. Meanwhile, it is difficult to achieve a high level of protection for the charging module, which may cause a shortened service life. Moreover, the cooling air blower is often located in the high-temperature zone of a cooling air duct, such as at an air outlet, causing high energy consumption, a short service life, and a poor actual cooling effect of the cooling air blower.

### SUMMARY

An object of the present application is to provide a charging device, which is direct to ensure the service life of the air blower while also improve the heat dissipation efficiency and use safety of the charging module, thereby providing a reliable use of the charging device.

To achieve the object, a charging device is provided in the present application, including:
a case, which is provided with an accommodation chamber, an air inlet and an air outlet that are in communication with the accommodation chamber;
a charging unit, which is located in the accommodation chamber and includes a charging module for battery charging; and
an air blower, which is positioned at the air inlet to introduce cold air to flow into the accommodation chamber through the air inlet, flow through the charging module and then be discharged through the air outlet.

In an embodiment, a gap is provided between the air blower and the charging module for cold air flowing there through.

In an embodiment, the charging module includes a housing, and a sealed chamber for accommodating a conversion device is provided in the housing.

In an embodiment, a heat dissipation device is provided on an exterior of the housing.

In an embodiment, the housing is provided with multiple side surfaces, the heat dissipation device includes a radiating fin, and the radiation fin is located on at least one side surface.

In an embodiment, the air inlet is aligned with the radiating fin.

In an embodiment, the charging device further includes an air baffle fixed inside the accommodation chamber and extending towards the air outlet to guide air inside the accommodation chamber to the air outlet.

In an embodiment, the case includes a front plate, a back plate, and a top plate connecting the front plate and the back plate, and the front plate and the back plate are arranged in opposite, where the air inlet is formed on the front plate and the air outlet is formed on at least one of the back plate and the top plate, or the air inlet is formed on the back plate and the air outlet is formed on at least one of the front plate and the top plate.

In an embodiment, the charging module includes multiple charging modules, which are arranged in array along a height direction and a width direction of the case, respectively.

In an embodiment, at least two columns of the multiple charging modules are staggered, and/or at least two rows of the multiple charging modules are staggered.

In an embodiment, a partition plate is further arranged inside the case, and the partition plate partitions the accommodation chamber to form a first chamber and at least one second chamber, and the charging module is located in the first chamber and the second chamber is configured to accommodate an electrical component.

In an embodiment, the partition plate is provided with an air vent to allow a part of the air to enter the second chamber for heat dissipation of the electrical component.

In an embodiment, the second chamber is arranged above the first chamber, or
the second chamber is arranged below the first chamber, or
the second chamber is arranged on a side of the first chamber, or
at least two second chambers are provided, which are arranged around the first chamber.

In the present application, the charging module is arranged between the air inlet and the air outlet and the air blower is located close to the air inlet, which is positioned in a low-temperature area, avoiding the hot air backflow from affecting the operation of the air blower. Under the action of the air blower, a cold air outside the device may be drawn into the accommodation chamber through the air inlet. Due to the pressure difference, the cold air flows over the surface of the charging module and flows towards the air outlet and is discharged outside of the device through the air outlet. During this process, the cold air absorbs the heat generated by the charging module and becomes the heated air, reducing the overall heat of the case, lowering the temperature inside the accommodation chamber and the temperature of the charging module, which ensures both the service life of the air blower and enhances the heat dissipation efficiency and the uses safety of the charging module, ensuring a reliable use of the charging device.

### BRIEF DESCRIPTION OF THE DRAWINGS

In order to clearly illustrate embodiments of the present application or technical solutions in the conventional technology, a brief introduction will be made to the accompanying drawings in the embodiments or conventional technology. Apparently, the accompanying drawings in the following description are merely some embodiments of the present application. For those skilled in the art, other accompanying drawings can be also obtained based on these drawings without paying a creative work.
FIG. 1 is a schematic structural view of a charging device according to an embodiment of the present application;
FIG. 2 is a left view of the charging device in FIG. 1;
FIG. 3 is a schematic structural view of a charging device according to another embodiment of the present application ;
FIG. 4 is a left view of the charging device in FIG. 3; and
FIG. 5 is a schematic structural view of a charging module.

### Numeral References in the accompanying drawings:

| | | | |
|---|---|---|---|
| 10 | case, | 15 | partition plate, |
| 10a | accommodation chamber, | 16a | first chamber, |
| 10b | air inlet, | 16b | second chamber, |
| 10c | air outlet, | 20 | charging unit, |
| 11 | front plate, | 21 | charging module, |
| 12 | back plate, | 21a | housing, |
| 13 | top plate, | 21b | radiating fin, |
| 14 | air baffle, | 30 | air blower, |
| 14a | guide air duct. | | |

The implementation, functional characteristics, and advantages of the present application will be further explained in conjunction with embodiments and with reference to the accompanying drawings.

### DETAILED DESCRIPTION OF THE EMBODIMENTS

The following will provide a clear and complete description to the technical solution in the embodiments of the present application, in conjunction with the accompanying drawings. Apparently, the described embodiments are merely a part of the embodiments of the present application, not all of them. Based on the embodiments in the present application, all other embodiments obtained by those skilled in the art without paying a creative work will fall within the scope of protection of the present application.

In the present application, unless otherwise expressly specified and limited, terms such as "connection" and "fixing" should be broadly understood. For example, "fixing" can be a fixed connection, a detachable connection, or being integral, and it can be a mechanical connection or an electrical connection, and it can be directly connected or indirectly connected through an intermediate medium, and it can be an internal connection of two components or the interaction relationship between two components, unless otherwise clearly limited. For those skilled in the art, the specific meanings of the above terms in the present application can be understood according to the specific circumstances.

In addition, in the present application, if there is a description of "first," "second," etc., it is only used for the purpose of description and cannot be understood as indicating or implying the relative importance or implying the quantity of the indicated technical features. Therefore, the limitation of "first," "second," etc., can explicitly or implicitly include at least one of that feature. Furthermore, the technical solutions between different embodiments can be combined, but it must be based on what those skilled in the art in this field can achieve. When the combination of technical solutions contradicts each other or cannot be realized, it should be considered that the combination of these technical solutions does not exist and is not within the scope of protection required by the present application.

A charging device is provided in the present application.

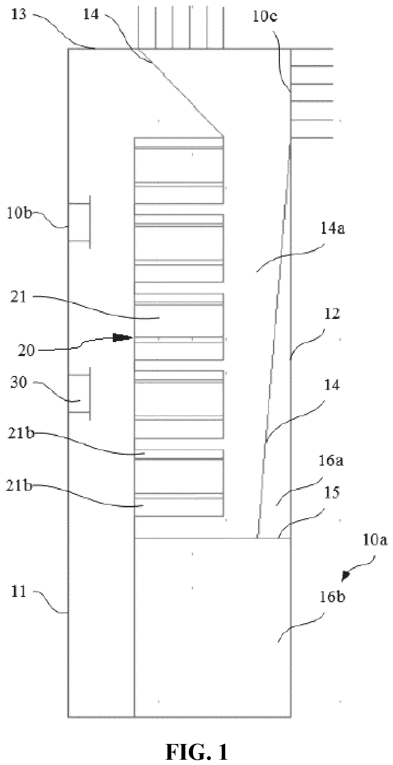

Referring to FIG. 1 to FIG. 5, in the embodiments of the present application, the charging device includes a case 10, a charging unit 20, and an air blower 30. The case 10 is provided with an accommodation chamber 10a and an air inlet 10b and an air outlet 10c that are in communication with the accommodation chamber 10a. The charging unit 20 is located in the accommodation chamber 10a and includes a charging module 21 for battery charging. The air blower 30 is positioned at the air inlet 10b to introduce cold air to flow into the accommodation chamber 10a through the air inlet 10b, then flow through the charging module 21 and be discharged through the air outlet 10c. It can be understood that the air blower 30 is located in a low-temperature area, i.e., at the air inlet 10b, to prevent a hot air from flowing back so as to affect the operation of the air blower 30. The charging module 21 is positioned between the air inlet 10b and the air outlet 10c. Under the action of the air blower 30, cold air outside the device is drawn into the accommodation chamber 10a through the air inlet 10b, creating a pressure differential that causes the cold air to flow over the surface of the charging module 21 and flow towards the air outlet 10c and then be discharged to the outside of the device. During this process, the cold air absorbs the heat generated by the charging module in a manner of heat exchanging and becomes heated air, reducing the overall heat of the case 10 and lowering the temperature inside the accommodation chamber 10a and the temperature of the charging module 21, which not only ensures the service life of the air blower 30 but also enhances the heat dissipation efficiency and the use safety of the charging module 21, providing a reliable use of the charging device.

The case 10 has a high protection level, and/or the charging unit 20 has a high protection level, ensuring the charging module 21 to be in a well-sealed environment, thus preventing a potential malfunction or even failure caused by adverse conditions such as strong wind, heavy rain, or high temperature.

The air inlet 10b and the air outlet 10c are provided on the case 10. Multiple the air inlets 10b may be provided at the top or on the side of the case 10 and in communicating with the air outlet 10c through the accommodation chamber 10a. In that case, multiple air outlets 10 may be provided on the side or at the top as long as it ensures that the air flowing in through the air inlet 10b can flow over the charging module 21 and be discharged through the air outlet 10c, which is not limited here.

The air blower 30 is located at the air inlet 10b, at a cold end of the airflow path formed by the communication between the air inlet 10b and the air outlet 10c. In this case, the temperature of the environment where the air blower 30 is located is lower than that at the air outlet 10c, ensuring the service life of the air blower 30 and avoiding the service life of the air blower 30 from being shortened by a high environmental temperature or a hot air backflow. The air blower 30 can be a centrifugal air blower 30, a fan, or any device capable of introducing cold air into the case 10, and multiple air blowers can be provided according to requirements.

The charging unit 20 is used to charge electrical devices. Specifically, the charging unit 20 is directly or indirectly connected to electrical devices in order to charging them. In this embodiment, the charging module 21 of the charging unit 20 is a power conversion module for converting the power for inputting the charging module 21 into the power required by the electrical devices, realizing the charging process for the electrical devices. Multiple charging modules 21 can be provided, which are arranged in parallel to provide the required power for the electrical devices, making it suitable for small charging locations such as charging posts as well as for large charging locations such as large-scale charging stations. That is, the charging unit 20 can be provided with multiple charging modules 21 to achieve a power stack, so that, during the charging process, different numbers of charging modules 21 can be turned on based on the power demand during charging, enabling the charging device to charge different electrical devices, which makes the usage scenarios of charging devices diverse and adaptable .

The charging device may be a charging post, a charging station and so on.

In the present application, the charging module 21 is arranged between the air inlet 10b and the air outlet 10c and the air blower 30 is located close to the air inlet 10b, which is positioned in a low-temperature area, avoiding the hot air backflow from affecting the operation of the air blower 30. Under the action of the air blower 30, cold air outside the device is drawn into the accommodation chamber 10a through the air inlet 10b. Due to the pressure difference, cold air flows over the surface of the charging module 21, flows towards the air outlet 10c and then is discharged outside of the device through the air outlet 10c. During this process, cold air absorbs the heat generated by the charging module 21 and becomes heated air, reducing the overall heat of the case 10, lowering the temperature inside the accommodation chamber 10a and the temperature of the charging module 21, which ensures the service life of the air blower 30 and improves the heat dissipation efficiency and the use safety of the charging module 21, further ensuring a reliable use of the charging device.

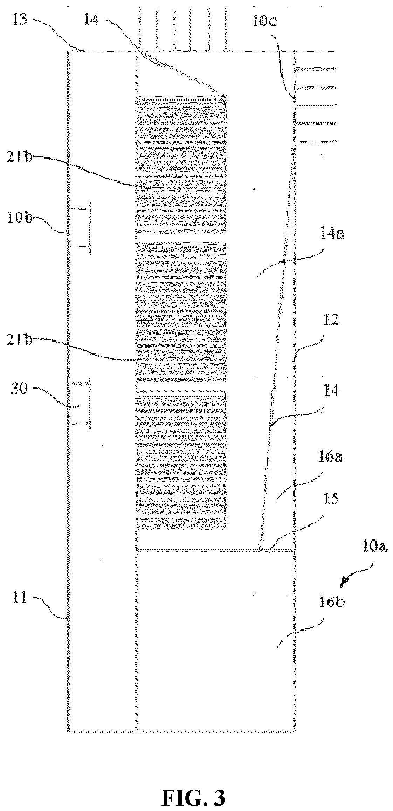

Referring to FIG. 1 and FIG. 3, a gap is provided between the air blower 30 and the charging module 21 for the cold air flowing there through. That is, sufficient cold air can be filled between the air blower 30 and the charging module 21. With this configuration, it facilitates of extending the duration of cold air inside the accommodation chamber 10a and increasing the amount of cold air inside the accommodation chamber 10a, making cold air sufficiently contact the charging module 21 for heat exchanging, thereby the heat dissipation efficiency of the charging module 21 is improved.

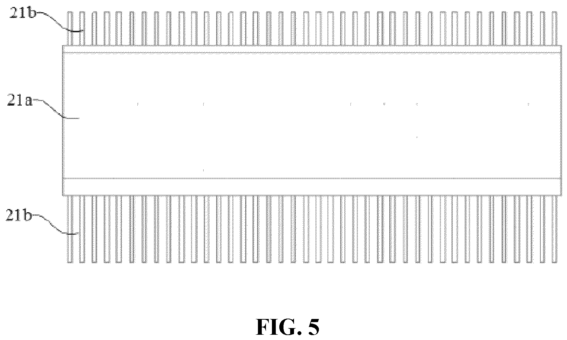

Referring FIG. 5, in an embodiment, the charging module 21 includes a housing 21a. A sealed chamber for accommodating the conversion device is provided in the housing 21a. With this configuration, it can ensure that the charging module 21 has a high level of protection, thus avoiding a damage of the conversion device inside the charging module 21 caused by an external environmental affection and improving the use reliability of the charging module 21, thus reducing maintenance costs and improving the use safety of the charging device.

The main heat source in the charging device is the charging module 21, which generates a significant amount of heat during operation, causing an increase of the overall temperature of the device. In order to ensure a normal operation of the components inside the charging module 21, the charging device needs to be timely cooled. Therefore, in the embodiment, a heat dissipation device is provided on the exterior of the housing 21a to implement an independent heat dissipation for the charging module 21. Since the charging module 21 itself does not have a heat dissipation module, the heat dissipation of the charging module 21 is achieved merely through the cooperation of the heat dissipation device and the air blower 30 of the charging device to implement heat exchanging between the cold air and the heat dissipation device, thus the cost is low, the noise is controllable and the effect of heat dissipation is significantly improved.

Specially, in an embodiment, the housing 21a is provided with multiple side surfaces, and the heat dissipation device is a radiating fin 21b located on at least one side surface. It can be understood that the housing 21a is enclosed by multiple side surfaces. In case that the heat dissipation device is the radiating fin 21b, multiple radiating fins 21b may be provided, which are arranged on one side surface, or arranged on opposite side surfaces, or arranged on each side surface, so as to ensure a relatively large effective contact area between cold air drawn in through the air inlet 10b and the multiple radiating fins 21b, thereby greatly improving the heat dissipation efficiency of the charging module 21 and ensuring the reliable use of the charging module 21. Alternatively, the present application is not limited to this, where, in other embodiments, the heat dissipation device may be in the form of slots formed on the surface of the housing 21a.

In addition, in an embodiment, the air inlet 10b and the multiple radiating fins 21b are aligned. As such, when being drawn in through the air inlet 10b by the air blower 30, cold air can flow directly towards the multiple radiating fins 21b and disperse, so as to concentrate most of the cold air to act on the multiple radiating fins 21b, which shortens the path for cold air to the charging module 21 and increases the heat dissipation rate of the charging module 21.

In an embodiment, in order to direct the airflow inside the accommodation chamber 10a towards the air outlet 10c, the charging device further includes an air baffle 14, which is fixed inside the accommodation chamber 10a and extending towards the air outlet 10c, so as to guide the air inside the accommodation chamber 10a towards the air outlet 10c. As such, it can guide the air after being in heat exchanging with the charging module 21 to concentrate the air after being in heat exchanging with the charging module 21 at the air outlet 10c to be further discharged when more external cold air is drawn into the accommodation chamber 10a by the air blower 30, thereby lowering the temperature inside the accommodation chamber 10a.

In addition, in an embodiment, at least one air baffle 14 is provided, and forms a guide air duct 14a together with the case 10 and one side of the charging module 21 away from the air inlet 10b. The guide air duct 14a is in communication with the air outlet 10c, that is, a side wall of the case 10, the side of the charging module 21 away from the air inlet 10b, and the air baffle 14 enclose to form a guide air duct 14a, which is conducive to concentrating the air after being heat exchanged at the air outlet 10c, facilitating the discharge of the heat-exchanged air, and improving the heat dissipation efficiency. Multiple air baffles 14 may be provided to gather the air after being heat exchanged from various directions inside the case 10. The multiple air baffles 14 may be in an integrated structure, and their specific form can be configured to match with the location of the air outlet 10c on the case 10. Alternatively, the multiple air baffles 14 may be of a detachable structure, for example, being secured through splicing, snap fitting, and other connection methods for easy disassembly and assembly.

One end of the air baffle 14 is connected to the side wall of the case 10 and is located close to the air outlet 10c. The other end can be directly suspended above/below the side of the charging module 21 away from the air inlet 10b, or on the side portion at the side the charging module 21 away from the air inlet 10b, or connected to the other side wall of the case 10, so as to ensure the air flowing through the charging module 21 to flow towards the air outlet 10c.

Specifically, in an embodiment, the air baffle 14 is inclined towards the air outlet 10c to guide the air flowing towards the outlet 10c. It can be understood that, by inclining the air baffle 14 towards the air outlet 10c, i.e., based on the position relationship between the side of the charging module 21 away from the air inlet 10b and the air outlet 10c, the rear end of the air baffle 14 can be gradually expanded or tapered towards the direction away from the air outlet 10c, which can further reduce the range of air escape, facilitate the concentration of heat exchange air, improve the flowing rate of the air towards the direction of the air outlet 10c, and improve heat dissipation efficiency. The air baffle 14 may be a straight plate with a simple structure and easy disassembly. Alternatively, the air baffle 14 may also be an arc-shaped plate, which is designed according to the location of the charging module 21 and the air outlet 10c to match the direction of air flow with the arc-shaped structure of the air baffle 14, so as to better guide the heat-exchanged air to flow to the air outlet 10c and further improve the guiding effect of the air baffle 14.

Referring to FIG. 1, in an embodiment, the case 10 includes a front plate 11 and a back plate 12 that are arranged in opposite, and a top plate 13 connecting the front plate 11 and the back plate 12. The air inlet 10b is formed on the front plate 11, and the air outlet 10c is formed on at least one of the back plate 12 and the top plate 13. Alternatively, the air inlet 10b is formed on the back plate 12, and the air outlet 10c is formed on at least one of the front plate 11 and the top plate 13. It can be understood that, for example, if the air inlet 10b is formed on the front plate 11, when only one air outlet 10c is provided, the air outlet 10c may be formed in the back plate 12 close to the top plate 13, or in the top plate 13 close to the back plate 12. When multiple air outlets 10c are provided, the air outlets 10c may be formed on the back plate 12 close to the top plate 13 and in the top plate 13 close to the back plate 12, respectively, which ensures the heat exchanged air to rise after passing through the charging module 21 and is then discharged through the air outlet 10c with a low resistance and a high discharging rate, thereby improving the heat dissipation efficiency. The present application is not limited to this, and in other embodiments, the air outlet 10c may be formed in the middle of the back plate 12 or at the bottom of the back plate 12, which can shorten the distance of the air flowing through part of the charging module 21 flowing to the air outlet 10c.

If the air inlet 10b is formed on the back plate 12, when only one air outlet 10c is provided, the air outlet 10c may be formed in the front plate 11 close to the top plate 13 or in the top plate 13 close to the front plate 11. When multiple air outlets 10c are provided, the air outlet 10c may be formed in the front plate 11 close to the top plate 13 and in the top plate 13 close to the front plate 11, respectively, which ensures the heat-exchanged air to rise after passing through the charging module 21 and be then discharged through the air outlet 10c with a low resistance and a high discharging rate, thereby improving the heat dissipation efficiency. The present application is not limited to this, and in other embodiments, the air outlet 10c may be formed in the middle of the front plate 11 or at the bottom of the front plate 11, which can shorten the distance of the air flowing through part of the charging module 21 flowing to the air outlet 10c.

Referring to FIG. 1 to FIG. 2, in an embodiment, multiple charging modules 21 are provided, which are arranged in array along the height and width directions of the case 10. That is, according to the size of the case 10 and power requirements, the multiple charging modules 21 may be arranged in a single column, single row, or multiple rows and columns. With the superposition of the multiple charging modules 21, i.e., different numbers of charging modules 21 connected in parallel, the required power of the electrical equipment can be provided, thereby completing charging and enhancing the adaptability of the charging device, and making it suitable for various charging locations.

Further, in an embodiment, at least two rows of the charging modules 21 are staggered, and/or at least two rows of charging modules 21 are staggered. With this configuration, it can extend the retention duration of cold air inside the accommodation chamber 10a, ensuring each charging module 21 inside the accommodation chamber 10a to come into full contact with the cold air, thereby implementing the heat exchanging between the cold air and the radiating fins 21b on the charging module 21, and the heat dissipation efficiency of the charging modules 21 is improved and the use reliability and the use safety of the charging device are improved.

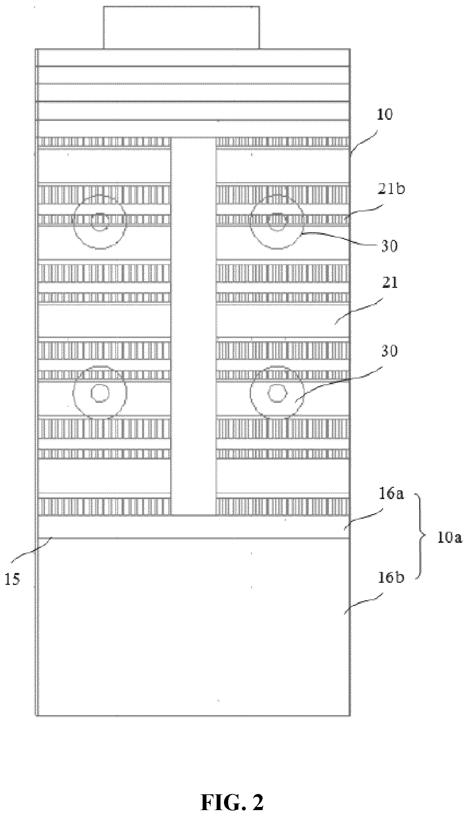

In addition, when the opposite surfaces of each charging module 21 are provided with the aforementioned heat dissipation device, such as radiating fins 21b, taking the height direction of the case 10 as a reference, as shown in FIG. 1 and FIG. 2, the charging module 21 are spaced apart along the height direction of the case 10, and the radiating fins 21b are arranged on the upper and lower surfaces of the charging module 21, respectively. In this case, multiple air inlets 10b may be provided, which are all aligned with the radiating fins 21b of the charging module 21. Alternatively, in other embodiments, only a part of air inlets 10b are aligned with the radiating fins 21b of a part of charging module 21.

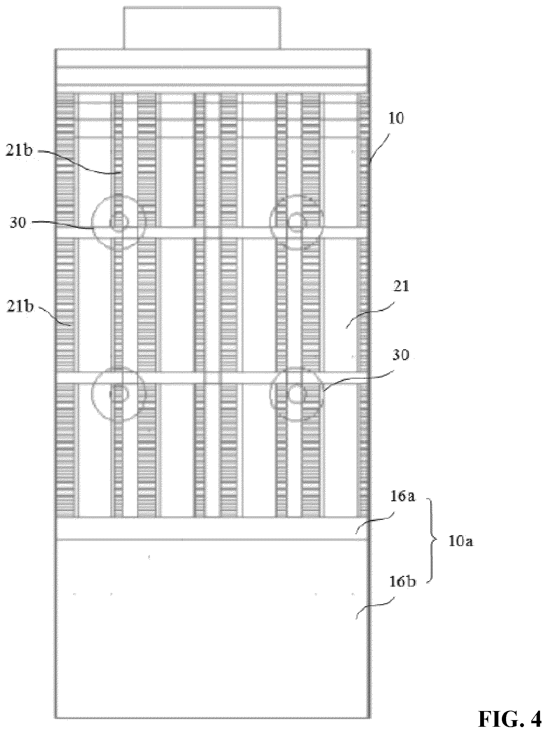

As shown in FIG. 3 and FIG. 4, the charging modules 21 are spaced apart along the height direction of the case 10, and the radiating fins 21b are located on the left and right surfaces of the charging modules 21, respectively. In this case, multiple air inlets 10b may be provided, which are all aligned with the radiating fins 21b of the charging modules 21. Alternatively, in other embodiments, only a part of air inlets 10b are aligned with the radiating fins 21b of a part of charging modules 21.

Referring to FIG. 1 to FIG. 4, in an embodiment, the case 10 further includes a partition plate 15, which partitions the accommodation chamber 10a to form a first chamber 16a and a second chamber 16b. The charging modules 21 are located in the first chamber 16a, and the second chamber 16b is used to accommodate the electrical components, so that the charging modules 21 can be isolated from the electrical components, which blocks the heat transferring between the charging modules 21 and the electrical components and thus decreases the affection on the function of the electrical components caused by heat, thereby ensuring the reliable use of the charging device. Herein, the electrical components may be a circuit breaker, a diverter, a power supply, an electricity meters and so on.

Specially, in an embodiment, the partition plate 15 is provided with an air vent to allow a part of air to enter the second chamber 16b for heat dissipation of the electrical components. With this configuration, a part of cold air flowing in through the air inlet 10b is directed to the second chamber 16b for heat dissipation of the electrical components, which is beneficial to prolonging the service life of the electrical components and ensures their proper functioning. Alternatively, the partition 15 may be designed without air vents, that is, completely isolating the charging modules 21 from the electrical components.

Specifically, the first chamber 16a and the second chamber 16b can be positioned in any of the following: the second chamber 16b is arranged above the first chamber 16a, or, the second chamber 16b is arranged below the first chamber 16a, or the second chamber 16b is arranged on a side of the first chamber 16a, or multiple second chambers 16b are provided, which are arranged around the first chamber 16a. It can be understood that the accommodation chamber 10a is partitioned by the installation position of the partition 15 inside the accommodation chamber 10a to form a specific position layout of the first chamber 16a and the second chamber 16b, which ensures the actual installation position of the charging modules 21 and the electrical components, and meets the actual installation requirements of the charging modules 21 and the electrical components.

In order to improve the heat exchange efficiency and increase air intake, in an embodiment, as shown in FIG. 1 and FIG. 2, multiple air inlets 10b and multiple air blowers 30 are provided, and the multiple air inlets 10b and the multiple air blowers 30 are arranged in one-to-one correspondence. Specifically, when the air inlets 10b are located on the front plate 11 of the case 10, multiple air inlets 10b are arranged side by side and spaced apart on the front plate 11, directly facing the charging modules 21. Each air blower 30 is then installed at the corresponding air inlet 10b, which can shorten the distance of the cold air to reach the charging modules 21, allowing for rapid and thorough heat exchange with each charging module 21 and thereby improving the heat exchange efficiency. It should be noted that the air inlets 10b may also be located on the top plate 13 or the back plate 12 as long as their specific location position is matched with the air outlet 10c.

Specifically, the air blower 30 is a centrifugal air blower with low noise. More specific, the air blower 30 may be a high air volume centrifugal air blower, which provides high air pressure and thus has a long air-supply range, allowing the air flowing in the accommodation chamber 10a to be effectively discharged to the outside of the case 10, preventing the air passing through the charging modules 21 from accumulating inside the chamber 10a after being heat exchanged (which cannot reliably reduce the overall heat of the case 10), and lowering the temperature of the accommodation chamber 10a. Meanwhile, the high air volume characteristic ensures a sufficient amount of cold air to be drawn in, thereby improving the heat exchange efficiency. Alternatively, the air blower 30 may be an axial air blower, which provides a large air flow and draw a large amount of cold air into the case 10 for heat exchanging.

When multiple air blowers 30 are provided, a centrifugal air blower and an axial air blower may be provided simultaneously, or all are centrifugal air blowers. With this configuration, it meets the heat dissipation requirements of the charging device, thereby enhancing the use safety and the use reliability of the charging device.

The described above are merely optional embodiments of the present application and does not intend to limit the scope of the present application. Any structural modifications made by the content of the present application and the accompanying drawings as well as the direct or indirect applications in other related technical fields under the inventive concept of the present application are all included within the scope of the protection scope of the present application.

## Claims

1. A charging device, comprising:
a case, which is provided with an accommodation chamber and an air inlet and an air outlet that are in communication with the accommodation chamber;
a charging unit, which is located in the accommodation chamber and comprises at least one charging module for battery charging; and
an air blower, which is positioned at the air inlet to introduce cold air to flow into the accommodation chamber through the air inlet, flow through the charging module and then be discharged through the air outlet.

2. The charging device according to claim 1, wherein
a gap is provided between the air blower and the charging module for cold air flowing there through.

3. The charging device according to claim 1, wherein
the charging module comprises a housing, and a sealed chamber for accommodating a conversion device is provided in the housing.

4. The charging device according to claim 3, wherein
a heat dissipation device is provided on an exterior of the housing.

5. The charging device according to claim 4, wherein
the housing is provided with a plurality of side surfaces, the heat dissipation device is a radiating fin, and the radiation fin is located on at least one side surface.

6. The charging device according to claim 5, wherein
the air inlet is aligned with the radiating fin.

7. The charging device according to claim 1, wherein
the charging device further comprises an air baffle fixed inside the accommodation chamber and extending towards the air outlet to guide air inside the accommodation chamber to the air outlet.

8. The charging device according to claim 1, wherein
the case comprises a front plate, a back plate, and a top plate connecting the front plate and the back plate, and the front plate and the back plate are arranged in opposite,
wherein the air inlet is formed on the front plate and the air outlet is formed on at least one of the back plate and the top plate, or the air inlet is formed on the back plate and the air outlet is formed on at least one of the front plate and the top plate.

9. The charging device according to claim 1, wherein
a plurality of charging modules are provided, which are arranged in array along a height direction and a width direction of the case, respectively.

10. The charging device according to claim 9, wherein
at least two columns of the plurality of charging modules are staggered, and/or
at least two rows of the plurality of charging modules are staggered.

11. The charging device according to claim 1, wherein
a partition plate is further arranged inside the case, and the partition plate partitions the accommodation chamber to form a first chamber and at least one second chamber,
the charging module is located in the first chamber and the second chamber is configured to accommodate an electrical component.

12. The charging device according to claim 11, wherein
the partition plate is provided with an air vent to allow a part of the air to enter the second chamber for heat dissipation of the electrical component.

13. The charging device according to claim 11, wherein
the second chamber is arranged above the first chamber, or
the second chamber is arranged below the first chamber, or
the second chamber is arranged on a side of the first chamber, or
at least two second chambers are provided, which are arranged around the first chamber.
